# EUROPEAN PATENT APPLICATION

(11) **EP 4 847 471 A1**
(43) Date of publication of application: **02.12.2026**
(21) Application number: 25744877.9
(22) Date of filing: 10.01.2025
(51) Int. Cl.: C04B 35/587, H01L 23/36, H01L 23/373, H05K 1/03

(54) **SILICON NITRIDE SINTERED BODY AND SILICON NITRIDE HEAT DISSIPATION SUBSTRATE**

(30) Priority: 25.01.2024 JP 2024009502
(71) Applicant: Niterra Co., Ltd., Nagoya-shi, Aichi 461-0005 (JP)
(72) Inventor: MOTEKI, Jun, Nagoya-shi, Aichi 461-0005 (JP); IHARA, Akio, Nagoya-shi, Aichi 461-0005 (JP); IKAI, Yoshihito, Nagoya-shi, Aichi 461-0005 (JP); MITSUOKA, Takeshi, Nagoya-shi, Aichi 461-0005 (JP)
(74) Representative: Grünecker Patent- und Rechtsanwälte PartG mbB
(86) International application number: PCT/JP2025/000720
(87) International publication number: WO 2025/158945

(57) **Abstract**

To provide a silicon nitride-based sintered body and a silicon nitride-based heat radiation substrate which achieve both high thermal conductivity and high mechanical strength. The silicon nitride-based sintered body mainly comprising silicon nitride-based grains and a grain boundary phase surrounding the silicon nitride-based grains, wherein the silicon nitride-based grains contain β-form silicon nitride; the grain boundary phase includes an Re₂Si₃O₃N₄-type crystal phase (wherein Re represents a rare earth element), the β-form silicon nitride has a Lotgering factor f(hk0) of 0.01 to 0.35 in an X-ray diffraction pattern obtained by a θ-2θ method in a 2θ range of 20 to 80°, and the Re₂Si₃O₃N₄-type crystal phase has a Lotgering factor f(hk0) of 0.01 to 0.35.

## Description

### TECHNICAL FIELD

The present invention relates to a silicon nitride-based sintered body and to a silicon nitride-based heat radiation substrate.

### BACKGROUND ART

Silicon nitride, having high thermal conductivity and mechanical strength, attracts attention as a material for electrically insulating heat radiation substrates of power modules for inverters installed in electric vehicles (EVs) and hybrid vehicles (HVs). Conventionally, aluminum nitride has been widely used as a material of electrically insulating heat radiation substrates. However, in the case of a power module for large current such as that for EVs, the temperature of the power module rises to about 250°C, and a large thermal stress is generated in its substrate due to the difference in thermal expansion between the substrate and a metal such as copper bonded thereto. As a result, the substrate formed of aluminum nitride having low mechanical strength is cracked or broken. Therefore, silicon nitride, which among general insulating ceramic materials is high in thermal conductivity and has higher mechanical strength, has been employed in an increasing number of cases, although the thermal conductivity of silicon nitride is lower than that of aluminum nitride.

Patent Document 1 has, regarding a silicon nitride-based or a Sialon-based ceramic material, an object of providing a method of molding a single-component material (not a composite material) employing super-plasticity to yield the silicon nitride or Sialon-based sintered body and a sintered body molded through the method. More specifically, the disclosed silicon nitride-based or Sialon-based ceramic material is a ceramic material which is substantially formed of silicon nitride or Sialon and which contains only a sintering aid as an additive component. The ceramic material is characterized in that the degree of orientation of the microstructure in a 2-dimensional cross-section of a sintered body after molding, in a direction parallel to the tensile direction or compressive direction in molding, falls within a range of 5 to 80% based on the technique defined by Saltykov, and has a linear density of crystal grains of 80 to 200 with respect to a length of 50 µm in a direction parallel to the tensile direction or perpendicular to the compressive direction in the 2-dimensional cross-section.

### PRIOR ART DOCUMENTS

### PATENT DOCUMENTS

Patent Document 1: JP3624225B

### SUMMARY OF THE INVENTION

### PROBLEM TO BE SOLVED BY THE INVENTION

In recent years, a power module is employed in high-temperature conditions. Thus, for a silicon nitride substrate, both an enhancement in high heat radiation performance by high thermal conductivity and high mechanical strength against thermal stress are required. In the case of a silicon nitride-based or a Sialon-based ceramic material as disclosed in Patent Document 1, when silicon nitride crystals are oriented toward a specific direction, the mechanical strength can be enhanced by orienting the β-form silicon nitride such that the c-axis is parallel to the substrate surface. However, in the direction perpendicular to the substrate surface, the a-axis which has lower thermal conductivity than the c-axis becomes oriented, resulting in a drop in thermal conductivity in the direction perpendicular to the substrate surface.

Under such circumstances, when a silicon nitride sintered body is used as an insulating heat radiation substrate of a power device, there has been required a new technique for achieving both high thermal conductivity and high mechanical strength.

The present invention has been conceived under such circumstances. Thus, an object of the invention is to provide a silicon nitride-based sintered body and a silicon nitride-based heat radiation substrate which achieve both high thermal conductivity and high mechanical strength.

### MEANS FOR SOLVING THE PROBLEMS

(1) In order to attain the aforementioned object, the present invention provides a silicon nitride-based sintered body with the following technical means. Accordingly, an application example of the silicon nitride-based sintered body of the present invention is directed to a silicon nitride-based sintered body mainly comprising silicon nitride-based grains and a grain boundary phase surrounding the silicon nitride-based grains, wherein the silicon nitride-based grains contain β-form silicon nitride; the grain boundary phase includes an Re₂Si₃O₃N₄-type crystal phase (wherein Re represents a rare earth element); the β-form silicon nitride has a Lotgering factor f(hk0) of 0.01 to 0.35 in an X-ray diffraction pattern obtained by a θ-2θ method in a 2θ range of 20 to 80°; and the Re₂Si₃O₃N₄-type crystal phase has a Lotgering factor f(hk0) of 0.01 to 0.35.
(2) In the silicon nitride-based sintered body according to the application example (1) above, the sintered body further contains an alkali/alkaline earth metal element; the alkali/alkaline earth metal element includes one or more elements selected from Mg and Ca; and the rare earth element includes one or more elements selected from Y, La, and Yb.
(3) In the silicon nitride-based sintered body according to the application example (1) or (2) above, the sintered body further contains a group 4 element, and at least a part of the group 4 element forms one or more compounds each containing nitrogen or carbon.
(4) In the silicon nitride-based sintered body according to any of the application examples (1) to (3) above, the alkali/alkaline earth metal element is contained in a total amount of 0.3 to 3.0 wt%, and the rare earth element is contained in a total amount of 1.0 to 6.5 wt%.
(5) An application example of the silicon nitride-based heat radiation substrate of the present invention is characterized by being formed of a silicon nitride-based sintered body according to any of (1) to (4) above.
(6) The silicon nitride-based heat radiation substrate according to the application example (5) above has a flexural strength of 700 MPa or higher.
(7) The silicon nitride-based heat radiation substrate according to the application examples (5) or (6) above has a thermal conductivity of 85 W/mK or higher.
(8) The silicon nitride-based heat radiation substrate according to any of the application examples (5) to (7) above has a thickness in a direction perpendicular to its one main face of 220 µm or more and 690 µm or less.

### EFFECTS OF THE INVENTION

According to the silicon nitride-based sintered body or the silicon nitride-based heat radiation substrate of the present invention, there can be provided a silicon nitride-based sintered body or a silicon nitride-based heat radiation substrate which achieves both high thermal conductivity and high mechanical strength.

### BRIEF DESCRIPTION OF THE DRAWINGS

[FIG. 1] FIG. 1 is a schematic view showing a cross-section of a silicon nitride-based sintered body, cut along a direction perpendicular to the main face thereof.
[FIG. 2] FIG. 2 is a schematic perspective view showing an example of a silicon nitride-based heat radiation substrate according to an embodiment of the present invention.
[FIG. 3] FIG. 3 is a schematic cross-sectional view showing an example of a power device employing the silicon nitride-based heat radiation substrate according to an embodiment of the present invention.
[FIG. 4] FIG. 4 is a table showing element contents, characteristics of the grain boundary phase, and characteristics of each sample.

### MODES FOR CARRYING OUT THE INVENTION

Embodiments of the present invention will now be described with reference to the drawings. In order to facilitate understanding of description, identical constituent elements in the drawings are denoted by the same reference numerals, and their redundant descriptions are omitted. Notably, in structural views, the sizes of constituent elements are conceptually represented and do not necessarily represent the actual dimensional ratios.

### [Embodiments]

### [Structures of silicon nitride-based sintered body]

Firstly, an embodiment of the silicon nitride-based sintered body of the present invention will be described. The silicon nitride-based sintered body according to the embodiment of the present invention is a silicon nitride-based sintered body mainly comprising silicon nitride-based grains and a grain boundary phase surrounding the silicon nitride-based grains. The term "silicon nitride-based grains" refers to silicon nitride grains or Sialon grains. However, since Sialon provides a lower thermal conductivity as compared with silicon nitride, the amount of Sialon is preferably adjusted to that generated within a range of the below-mentioned Al content as the upper limit. The expression "mainly comprising silicon nitride-based grains and a grain boundary phase surrounding the silicon nitride-based grains" allows presence of an impurity other than the below-mentioned elements of 0.5 wt% or less. The silicon nitride-based grains contain β-form silicon nitride.

The grain boundary phase includes an Re₂Si₃O₃N₄-type crystal phase (wherein Re represents a rare earth element). The crystal phase of the grain boundary phase can be identified through the results of X-ray diffraction (XRD) analysis. The Re₂Si₃O₃N₄-type crystal may be, for example, Y₂Si₃O₃N₄. Y₂Si₃O₃N₄ is called an M phase or a melilite phase and is identified by the powder diffraction file (PDF) card No. 00-045-0249 of the International Centre for Diffraction Data (ICDD). So long as the crystal system, space group, and conformation of constituent elements are common, the Re₂Si₃O₃N₄-type crystal may contain different elements. For example, the Re₂Si₃O₃N₄-type crystal may be Yb₂Si₃O₃N₄.

In the silicon nitride-based sintered body, the β-form silicon nitride has a Lotgering factor f(hk0) of 0.01 to 0.35 in an X-ray diffraction pattern obtained using the θ-2θ method in a 2θ range of 20 to 80°, and the Re₂Si₃O₃N₄-type crystal phase has a Lotgering factor f(hk0) of 0.01 to 0.35. Notably, in the present invention, the Lotgering factor is a value obtained through calculation of the analytical results of an X-ray diffraction pattern of the main face (a face having the largest area) of the silicon nitride-based sintered body. The Lotgering factor can be calculated by software attached to an X-ray diffractometer.

Lotgering factor f(hk0) is defined as a value calculated by the following numerical expression (1): $f \left(hk0\right) = \left(ρ-{ρ}_{0}\right) / \left(1-{ρ}_{0}\right)$ (1), wherein ${ρ}_{0} = {ΣI}_{0} \left(hk0\right) / {ΣI}_{0} \left(hkl\right)$ (2) $ρ = ΣI \left(hk0\right) / ΣI \left(hkl\right)$ (3). ρ₀ represents a value calculated from an X-ray diffraction intensity of a non-oriented comparative sample. ρ₀ may also be calculated by means of a PDF card of ICDD. p represents a value calculated from an X-ray diffraction intensity of a sample whose Lotgering factor is to be calculated. I0₍hk0), I₀(hkl), I(hk0), and I(hkl) represent peak intensities in an X-ray diffraction pattern of a non-oriented comparative sample or a silicon nitride-based sintered body corresponding to the following crystal faces. That is, Lotgering factor is an index for the degree of orientation with respect to a non-oriented sample.

### β-form silicon nitride:

·(hkl)=(110), (200), (101), (120), (111), (300), (201), (220), (121), (130), (301), (400), (221), (131), (230), (002), (140), (401), (102), (112), (321), (202), (500), (141), (330), (122), (240), (302), and (501).
·(hk0)=(110), (200), (120), (300), (220), (130), (400), (230), (140), (500), (330), and (240).

### Re₂Si₃O₃N₄-type crystal:

·(hkl)=(101), (200), (111), (210), (201), (211), (220), (002), (310), (221), (102), (301), (112), (311), (202), (212), (321), (400), (410), (222), (330), (401), (411), (312), (420), (331), (103), (322), (113), (402), (412), (332), (511), (422), (303), (521), (440), (530), (502), (600), (403), (601), (413), (611), and (333).
·(hk0)=(200), (210), (220), (310), (400), (410), (330), (420), (440), (530), and (600).

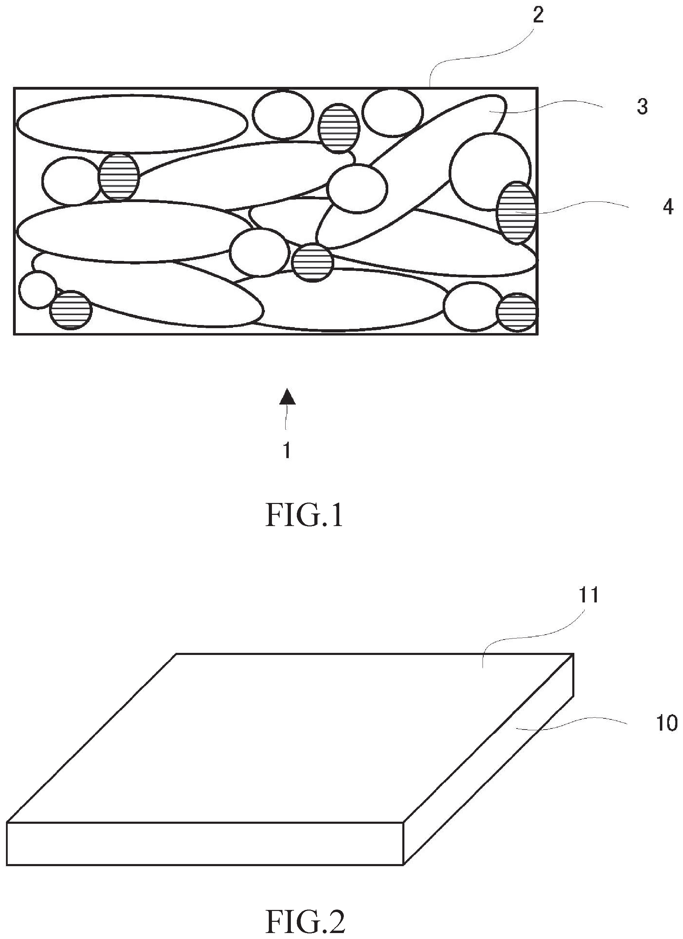

FIG. 1 is a schematic view showing a cross-section of a silicon nitride-based sintered body 1, cut along a direction perpendicular to a main face 2 thereof. By adjusting the Lotgering factor f(hk0) of β-form silicon nitride to fall within the above range, c-axis orientation of β-form silicon nitride 3 can be achieved in a direction parallel to the main face 2 of the silicon nitride-based sintered body 1 as shown in FIG. 1, whereby the mechanical strength can be enhanced. Also, by adjusting the Lotgering factor f(hk0) of the Re₂Si₃O₃N₄-type crystal phase to fall within the above range, a-axis orientation of an Re₂Si₃O₃N₄-type crystal 4 can be achieved in a direction perpendicular to the main face 2 of the silicon nitride-based sintered body 1 as shown in FIG. 1, whereby thermal conductivity can be enhanced.

The term a-axis orientation refers to a state in which the crystal direction of particular crystals statistically aligns in the a-axis direction in a specific face as compared with a random orientation state. The term c-axis orientation refers to a state in which the crystal direction of particular crystals statistically aligns in the c-axis direction in a specific face as compared with a random orientation state.

Preferably, the rare earth element includes one or more elements selected from yttrium (Y), lanthanum (La), and ytterbium (Yb). Also, the silicon nitride-based sintered body preferably contains the rare earth element in a total amount of 1.0 to 6.5 wt%. When the rare earth element content is lower than the lower limit of the range, sinterability decreases, and pores remain, whereby the mechanical strength of the silicon nitride-based sintered body may decrease in some cases. When the rare earth element content is higher than the upper limit of the range, the grain boundary phase content increases, whereby the thermal conductivity of the silicon nitride-based sintered body may decrease in some cases. Even when a rare earth element other than the aforementioned rare earth elements is included, the same effects are conceivably attained.

Preferably, the silicon nitride-based sintered body contains an alkali/alkaline earth metal element. In this case, the alkali /alkaline earth metal element preferably includes one or more elements selected from Mg and Ca. Also, the silicon nitride-based sintered body preferably contains the alkali/alkaline earth metal element in a total amount of 0.3 to 3.0 wt%. When the content of the alkali/alkaline earth metal element is lower than the lower limit of the range, the mechanical strength of the silicon nitride-based sintered body may decrease in some cases. When the content of the alkali metal element or alkaline earth metal element is higher than the upper limit of the range, the thermal conductivity of the silicon nitride-based sintered body may decrease in some cases. The term "alkali/alkaline earth metal element" refers to an alkali metal element or an alkaline earth metal element.

The silicon nitride-based sintered body preferably contains a group 4 element. Also preferably, the silicon nitride-based sintered body contains a group 4 element in a total amount of 0.30 to 3.0 wt%. Yet preferably, in the silicon nitride-based sintered body, at least a part of the group 4 element forms one or more compounds, the compounds each containing at least one of nitrogen and carbon.

When the group 4 element content falls within the above range, both high thermal conductivity and high mechanical strength can be attained. Since the group 4 element does not form a solid solution with silicon nitride, a drop in thermal conductivity caused by phonon scattering is not evoked. In addition, the group 4 element does not form a solid solution with a grain boundary phase formed via reaction between the rare earth element and silicon nitride. Thus, the group 4 element alone easily forms a compound, and residual pores are filled with the compound. As a result, the mechanical strength of the silicon nitride-based sintered body is enhanced. In addition, the group 4 element compound particles suppress propagation of cracking, thereby leading to high toughness. Notably, the "group 4 element compound" may also encompass a compound containing only a group 4 element and nitrogen or carbon; a compound containing a group 4 element, nitrogen, and carbon; and such a compound forming a solid solution with another group 4 element or an anion (e.g., oxygen), so long as the intrinsic crystal structure is stable. The group 4 element compound can be identified through results of X-ray diffraction (XRD) analysis.

The group 4 element preferably contains one or more elements selected from zirconium (Zr) and hafnium (Hf). In this case, more specific formulation of the group 4 element compound can be achieved. When the silicon nitride-based sintered body contains Zr, zirconium nitride (ZrN), zirconium carbide (ZrC), and zirconium carbide nitride (ZrCN) are easily formed as the group 4 element compound. When the silicon nitride-based sintered body contains Hf, hafnium nitride (HfN), hafnium carbide (HfC), and hafnium carbide nitride (HfCN) are easily formed as the group 4 element compound.

The silicon nitride-based sintered body may contain Al in an amount more than 0 wt% and 0.1 wt% or less. Al is an impurity originating from a raw material, and incorporation of Al improves sinterability of the silicon nitride-based sintered body, thereby increasing the mechanical strength of the silicon nitride-based sintered body. Also, when the Al content falls within the range, a drop in thermal conductivity caused by formation of Sialon is suppressed to a substantially negligible level. When the Al content is in excess of 0.1 wt%, the Sialon content of the silicon nitride-based sintered body increases, and the thermal conductivity of the silicon nitride-based sintered body may decrease in some cases.

By virtue of the aforementioned technical features, the silicon nitride-based sintered body can exhibit both high thermal conductivity and high mechanical strength.

### [Configuration of silicon nitride-based heat radiation substrate]

FIG. 2 is a schematic perspective view showing an example of a silicon nitride-based heat radiation substrate according to an embodiment of the present invention. A silicon nitride-based heat radiation substrate 10 according to the present invention is formed of the aforementioned silicon nitride-based sintered body 1, and has a surface generally parallel to the main face 2 of the silicon nitride-based sintered body 1 serving as a main face 11 of the silicon nitride-based heat radiation substrate 10. Specifically, in the silicon nitride-based heat radiation substrate 10 of the present invention, the β-form silicon nitride is oriented with its c-axis relative to a plane parallel to the main face 11, and the Re₂Si₃O₃N₄-type crystal is oriented with its a-axis relative to a plane perpendicular to the main face 11. Thus, both high thermal conductivity and high mechanical strength can be achieved. As a result, occurrence of any failure in a circuit substrate employing the heat radiation substrate can be reduced. The silicon nitride-based heat radiation substrate 10 of the present invention can be suitably used as a heat radiation substrate of a circuit substrate for power devices. The silicon nitride-based heat radiation substrate 10 is shaped into, for example, a plate.

The silicon nitride-based heat radiation substrate 10 preferably has a flexural strength of 700 MPa or higher. In this case, breaking of the silicon nitride-based heat radiation substrate 10 can be suppressed.

The flexural strength can be measured through the following procedure. Specifically, in accordance with ISO 23242, a silicon nitride-based heat radiation substrate is processed to specific dimensions of (fixed thickness) × 12 × 25 mm. Then, flexural strength is measured with a span of 15 mm by a three-point bending method. ISO 23242 may be applied to a ceramic thin plate having a thickness of 0.2 mm to 1.0 mm.

Preferably, the silicon nitride-based heat radiation substrate 10 has a thermal conductivity of 85 W/mK or higher. In this case, the performance as a heat radiation substrate can be fully achieved.

Thermal conductivity may be measured and calculated through the following procedure. Firstly, a silicon nitride-based heat radiation substrate 10 is processed into pieces having dimensions of 0.32 mm × 10 mm × 10 mm. Thermal diffusivity of each piece is measured through a xenon flash method. Also, the density of the silicon nitride-based heat radiation substrate 10 is measured in accordance with a method according to JIS R1634. Specific heat is fixed at a constant value of 0.68 cm²/sec. From the thus-obtained thermal diffusivity and density, thermal conductivity can be calculated by an equation: (thermal conductivity)=(density)×(specific heat)×(thermal diffusivity).

Preferably, the silicon nitride-based heat radiation substrate 10 has a thickness in a direction perpendicular to its one main face of 220 µm or more and 690 µm or less. In this case, the mechanical strength and heat radiation performance of the silicon nitride-based heat radiation substrate 10 can be achieved in a well-balanced manner. When the thickness is less than the lower limit of the range, the mechanical strength of the substrate decreases in some cases, whereas the thickness is greater than the upper limit of the range, heat radiation performance decreases in some cases.

### [Configuration of power device]

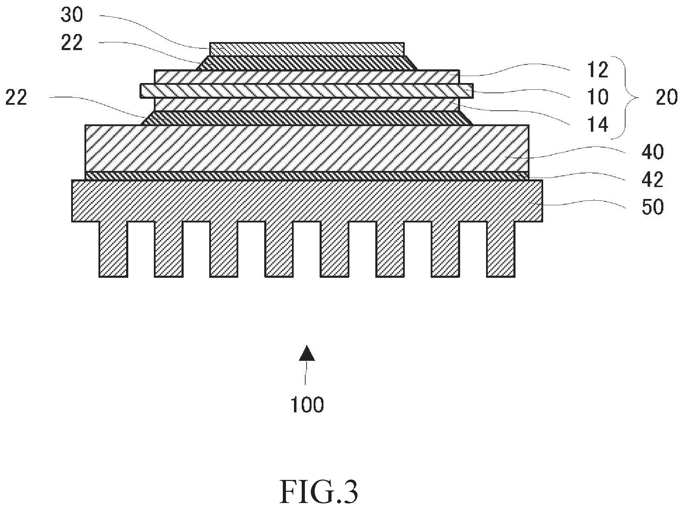

FIG. 3 is a schematic cross-sectional view showing an example of a power device employing the silicon nitride-based heat radiation substrate according to an embodiment of the present invention. A power device 100 has a circuit substrate 20, a power semiconductor 30, a heat radiation plate 40, and a heat radiation member 50.

The circuit substrate 20 has a circuit layer 12 formed on one main face of the silicon nitride-based heat radiation substrate 10, and a conductor layer 14 formed on the face opposing to the one main face. The circuit layer 12 and the conductor layer 14 are preferably formed of a metal, more preferably a metal mainly containing copper. The circuit layer 12 and the conductor layer 14 are joined directly to the silicon nitride-based heat radiation substrate 10 or by the mediation of a joining material such as braze.

On the circuit layer 12 of the circuit substrate 20, a power semiconductor 30 is mounted. The power semiconductor 30 and the circuit layer 12 may be joined together by use of a solder 22 or the like. The power semiconductor 30 may be formed of, for example, a semiconductor which allows passage of large current for EVs and is easily heated to high temperature. Since the silicon nitride-based heat radiation substrate 10 of the present invention exhibits high mechanical strength while high thermal conductivity is maintained, generation of cracking or the like is prevented, even when large thermal stress is generated in the silicon nitride-based heat radiation substrate 10 due to the high temperature-induced difference in thermal expansion between the silicon nitride-based heat radiation substrate 10 and the joining metal.

To the lower face of the conductor layer 14 of the circuit substrate 20, a heat radiation plate 40 is joined. The heat radiation plate 40 and the conductor layer 14 may be bonded together by use of a solder 22 or the like. The face opposite to the face joined to the conductor layer 14 of the heat radiation plate 40 is in contact with a heat radiation member 50 via a grease 42. The heat radiation plate 40 is preferably formed of a metal, more preferably a metal mainly containing copper. The heat radiation member 50 is provided with heat radiation fins. The heat radiation member 50 is preferably formed of a metal, more preferably a metal mainly containing copper or aluminum.

### [Method of manufacturing silicon nitride-based sintered body and silicon nitride-based heat radiation substrate]

An example of a method of manufacturing the silicon nitride-based sintered body and the silicon nitride-based heat radiation substrate will be described. Firstly, essential members are selected from the powder raw materials of the silicon nitride-based sintered body, and weighed to attain the target composition. The powder raw materials of the silicon nitride-based sintered body may be an oxide, a carbonate salt, a hydroxide, a nitride, etc. of the elements contained in the silicon nitride-based sintered body. In addition to silicon nitride (Si₃N₄), examples of the powder raw material of the silicon nitride-based sintered body include magnesium carbonate (MgCO₃), calcium carbonate (CaCO₃), yttrium oxide (Y₂O₃), ytterbium oxide (Yb₂O₃), lanthanum oxide (La₂O₃), and zirconium nitride (ZrN).

Ethanol is added to the powder raw materials, and the mixture is wet-pulverized by means of a ball mill for, for example, 6 to 60 hours, to thereby yield a slurry. The slurry is dried by heating on a hot water bath or by means of a spray drier or the like, to thereby prepare a powder mixture. In an alternative procedure, a binder (e.g., an acrylic binder) is added to the thus-obtained mixed slurry, and mixing is conducted for about 30 minutes, followed by drying.

Subsequently, the powder mixture is charged into a mold and shaped through monoaxial pressing at a pressure of, for example, 30 MPa, to thereby yield a molded body of desired shape. Thereafter, the molded body is subjected to a CIP treatment (cold isostatic pressing) at a pressure, for example, 100 MPa, to thereby yield a compact. The thus-obtained compact (i.e., a CIP press body) is maintained at 600°C for 2 hours in a flow of air, for example. Through the heat treatment (debindering), a debindered body is yielded.

Thereafter, the debindered body is placed in, for example, a silicon carbide mold having an inside coating of BN. The contents of the mold are maintained for firing at a maximum temperature of 1,900°C for 8 hours in a nitrogen atmosphere at 9 atm, while a load is applied in a specific direction. During firing, a crystal phase control step is provided in which the contents are maintained for a predetermined maintenance time at a crystal phase control temperature lower than the maximum temperature during temperature elevation and lowering. The crystal phase control temperature may be set to, for example, 1,800°C. The maintenance time in the crystal phase control step may be adjusted to a time which is 25% to 100% of the maintenance time at the maximum temperature. Through the aforementioned procedure, the silicon nitride-based sintered body is yielded.

In the case where the silicon nitride-based sintered body is employed as a silicon nitride-based heat radiation substrate, the sintered body is processed so as to provide a predetermined outer shape having a specific thickness. Examples of the processing which may be employed include cutting, grinding, and blasting.

Through the aforementioned manufacturing method, there can be produced a silicon nitride-based sintered body or a silicon nitride-based heat radiation substrate which exhibits both high thermal conductivity and high mechanical strength.

### [Examples and Comparative Examples]

### (Sample 1)

Silicon nitride powder (average particle size: 1.4 µm) in amount of 96.5 wt%, yttrium oxide powder (average particle size: 1.0 µm) in amount of 2.0 wt%, and magnesium carbonate powder (average particle size: 2.5 µm) in amount of 1.5 wt% were weighed. Next, the weighed powder raw materials were subjected to ball milling, to thereby prepare a mixed slurry. In ball milling, the powder raw materials and ethanol were put into a resin pot, and the mixture was pulverized by means of YSZ (i.e., Y₂O₃-partially stabilized zirconia) balls at 60 rpm for 24 hours. To the thus-obtained mixed slurry, a binder (an acrylic binder) was added, and mixing was further conducted for 30 minutes. The resultant slurry was dried through spray drying, to thereby yield a powder mixture.

The obtained powder mixture was mono-axially pressed and subjected to CIP, to thereby form a compact. In a specific procedure, firstly, the powder mixture was charged into a specialized mold and then preliminary molding was conducted through mono-axial pressing at 30 MPa. Subsequently, the preliminary compact was put into a specialized bag, and CIP molding was conducted at 100 MPa while the bag was evacuated.

Then, the thus-obtained compact was debindered. Debindering was conducted by maintaining the compact in a flow of air at a maximum temperature of 600°C for 2 hours. The debindered body was fired. In firing, the debindered body was maintained in an atmosphere of nitrogen (gas pressure: 9 atm) at a maximum temperature of 1,900°C for 8 hours. Also, a crystal phase control step of maintaining the debindered body at 1,800°C for 4 hours was provided during temperature elevation and lowering. The mold employed in firing was a silicon carbide mold having an inside coating of BN. Thus, a silicon nitride-based sintered body of sample 1 was produced.

### (Sample 2)

A silicon nitride-based sintered body of sample 2 was produced under the same conditions as sample 1, except that the amount of yttrium oxide powder was 3.0 wt%.

### (Sample 3)

A silicon nitride-based sintered body of sample 3 was produced under the same conditions as sample 1, except that the amount of yttrium oxide powder was 8.0 wt%.

### (Sample 4)

A silicon nitride-based sintered body of sample 4 was produced under the same conditions as sample 1, except that the amount of yttrium oxide powder was 3.0 wt%, the amount of magnesium carbonate powder was 1.0 wt%, and calcium carbonate powder (average particle size: 2.5 µm) was further added in an amount of 0.5 wt.%.

### (Sample 5)

A silicon nitride-based sintered body of sample 5 was produced under the same conditions as sample 2, except that yttrium oxide powder was changed to ytterbium oxide powder (average particle size: 1.2 µm).

### (Sample 6)

A silicon nitride-based sintered body of sample 6 was produced under the same conditions as sample 2, except that yttrium oxide powder was changed to lanthanum oxide powder (average particle size: 1.0 µm).

### (Sample 7)

A silicon nitride-based sintered body of sample 7 was produced under the same conditions as sample 2, except that the maintenance time in the crystal phase control step during temperature elevation and lowering was changed to 2 hours.

### (Sample 8)

A silicon nitride-based sintered body of sample 8 was produced under the same conditions as sample 2, except that the maintenance time in the crystal phase control step during temperature elevation and lowering was changed to 8 hours.

### (Sample 9)

A silicon nitride-based sintered body of sample 9 was produced under the same conditions as sample 2, except that the debindered body was fired in a silicon carbide mold with a BN inner coating to which carbon powder had been added.

### (Sample 10)

A silicon nitride-based sintered body of sample 10 was produced under the same conditions as sample 2, except that the balls employed in preparing a mixed slurry were changed from YSZ balls to silicon nitride balls.

### (Sample 11)

A silicon nitride-based sintered body of sample 11 was produced under the same conditions as sample 2, except that the crystal phase control step was not conducted during temperature lowering.

### (Sample 12)

A silicon nitride-based sintered body of sample 12 was produced under the same conditions as sample 2, except that the crystal phase control step was not conducted during temperature elevation.

### (Sample 13)

A silicon nitride-based sintered body of sample 13 was produced under the same conditions as sample 2, except that the crystal phase control step was not conducted during temperature elevation and temperature lowering.

### [Measurements]

Each obtained sample of the sintered bodies was evaluated by the following measurements after removing a surface portion from the fired surface to a depth of 0.25 mm or more through grinding.

### (Measurement of density)

The density of a sintered body of each sample was measured in accordance with JIS R1634.

### (Determination of element amount)

Through X-ray fluorescence (XRF) analysis of the polished surface obtained, the species and relative amounts of the elements forming each sintered body sample were determined.

### (Identification of constitutional phase)

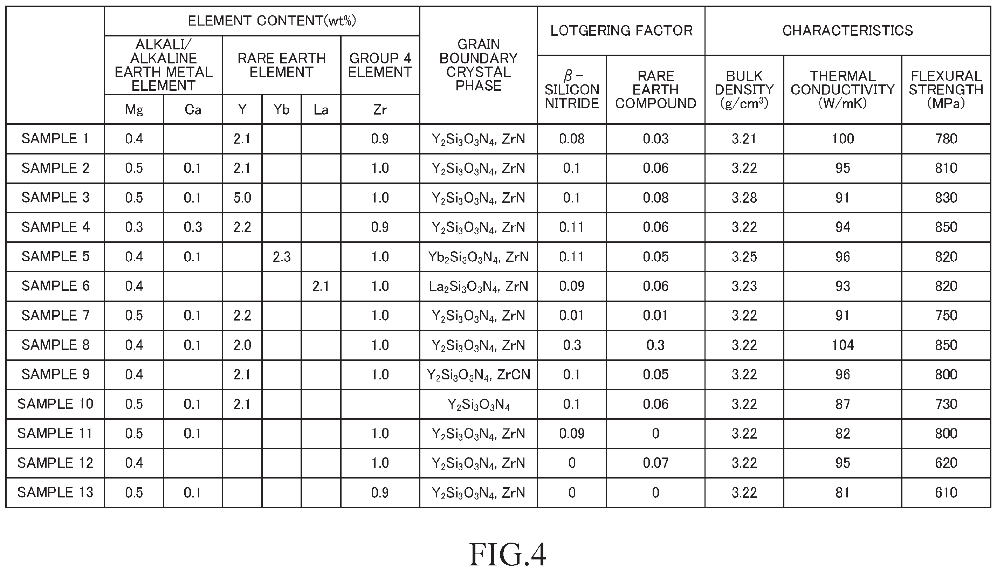

Through XRD analysis, the crystal phase in the grain boundary phase of each sample of a sintered body was identified. However, in the table of FIG 4, only components identified as crystalline components are shown, and information on the presence of amorphous components is omitted.

### (Calculation of Lotgering factor (LF))

Lotgering factor was calculated by the above-defined numerical expression, with reference to PDF card data of ICDD as that of a non-oriented comparative sample.

### (Calculation of thermal conductivity)

A sintered body of each sample was processed into pieces having dimensions of 0.32 mm × 10 mm × 10 mm. Thermal diffusivity of each piece was measured using a xenon flash method. The specific heat was fixed at a constant value of 0.68 cm²/sec. From the thermal diffusivity obtained using the xenon flash method and density, thermal conductivity was calculated according to the following equation: (thermal conductivity)=(density)×(specific heat)×(thermal diffusivity).

### (Measurement of flexural strength)

In accordance with ISO 23242, a sintered body of each sample was processed to dimensions of 0.32 (thickness) × 12 × 25 mm. Then, the flexural strength was measured with a span of 15 mm by a three-point bending method.

### (Results)

FIG. 4 is a table showing element contents, characteristics of the grain boundary phase, and characteristics of each sample. Notably, the group 4 element present in each sample (except for sample 10) originated from balls made of YSZ employed in the production step. All the samples 1 to 10 exhibited a thermal conductivity of 85 W/mK or higher, a flexural strength of 700 MPa or higher, indicating both high thermal conductivity and flexural strength.

Sample 11 exhibited low thermal conductivity. A conceivable reason is that, although the Lotgering factor of β-form silicon nitride satisfies the requirement, the Lotgering factor of Re₂Si₃O₃N₄-type crystal does not. The reason that the Lotgering factor of Re₂Si₃O₃N₄-type crystal does not satisfy the requirement is conceivably attributed to omission of the crystal phase control step during temperature lowering in a sintering step.

Sample 12 exhibited low flexural strength. A conceivable reason is that, although the Lotgering factor of Re₂Si₃O₃N₄-type crystal satisfies the requirement, the Lotgering factor of β-form silicon nitride does not. The reason that the Lotgering factor of β-form silicon nitride does not satisfy the requirement is conceivably attributed to omission of the crystal phase control step during temperature elevation in a sintering step.

Sample 13 exhibited low thermal conductivity and low flexural strength. A conceivable reason is that neither the Lotgering factor of β-form silicon nitride nor that of Re₂Si₃O₃N₄-type crystal satisfies the requirement. The reason that neither Lotgering factor satisfies the requirement is conceivably attributed to omission of the crystal phase control step during temperature elevation and lowering in a sintering step.

Based on the comparison between sample 2 and sample 9, regarding the group 4 element compound included in the silicon nitride-based sintered body, a compound containing a group 4 element and nitrogen and a compound containing a group 4 element, nitrogen, and carbon were found to play a common role. Furthermore, a compound containing a group 4 element and carbon may be conceivably acceptable as the group 4 element compound.

Sample 10 exhibited a slightly low thermal conductivity and a slightly low flexural strength. A conceivable reason is that a group 4 element compound is not incorporated into the silicon nitride-based sintered body. Thus, incorporation of the group 4 element compound into the silicon nitride-based sintered body was found to be preferable. In contrast, sample 10 exhibited a thermal conductivity and a flexural strength both higher than those of sample 13. In other words, even in the case of a silicon nitride-based sintered body containing no group 4 element compound, when both Lotgering factor of β-form silicon nitride and that of Re₂Si₃O₃N₄-type crystal satisfy the requirement, a higher thermal conductivity and a higher flexural strength were found to be achieved, as compared with the case in which the requirement was not satisfied.

The above-described test results have revealed that the silicon nitride-based sintered body and the silicon nitride-based heat radiation substrate of the present invention can achieve both high thermal conductivity and high mechanical strength.

Needless to say, the present invention is not limited to the above-described embodiments and encompasses various modifications and equivalents included in the idea and scope of the present invention. In addition, the structures, shapes, numbers, positions, sizes, etc. of the constituent elements shown in the drawings are for the convenience of description and may be changed as appropriate.

### DESCRIPTION OF REFERENCE NUMERALS

1: silicon nitride-based sintered body
2: main face
3: β-form silicon nitride
4: Re₂Si₃O₃N₄-type crystal
10 silicon nitride-based heat radiation substrate
11: main face
12: circuit layer
14: conductor layer
20: circuit substrate
22: solder
30: power semiconductor
40: heat radiation plate
42: grease
50: heat radiation member
100: power device

## Claims

1. A silicon nitride-based sintered body mainly comprising silicon nitride-based grains and a grain boundary phase surrounding the silicon nitride-based grains, wherein
the silicon nitride-based grains contain β-form silicon nitride;
the grain boundary phase includes an Re₂Si₃O₃N₄-type crystal phase (wherein Re represents a rare earth element); and
the β-form silicon nitride has a Lotgering factor f(hk0) of 0.01 to 0.35 in an X-ray diffraction pattern obtained by a θ-2θ method in a 2θ range of 20 to 80°; and the Re₂Si₃O₃N₄-type crystal phase has a Lotgering factor f(hk0) of 0.01 to 0.35.

2. The silicon nitride-based sintered body according to claim 1, wherein
the sintered body further contains an alkali/alkaline earth metal element;
the alkali/alkaline earth metal element includes one or more elements selected from Mg and Ca; and
the rare earth element includes one or more elements selected from Y, La, and Yb.

3. The silicon nitride-based sintered body according to claim 1 or 2, wherein
the sintered body further contains a group 4 element, and
at least a part of the group 4 element forms one or more compounds each containing nitrogen or carbon.

4. The silicon nitride-based sintered body according to claim 2, wherein
the alkali/alkaline earth metal element is contained in a total amount of 0.3 to 3.0 wt%, and
the rare earth element is contained in a total amount of 1.0 to 6.5 wt%.

5. A silicon nitride-based heat radiation substrate, **characterized by** being formed of the silicon nitride-based sintered body according to claim 1 or 2.

6. The silicon nitride-based heat radiation substrate according to claim 5, wherein
the substrate has a flexural strength of 700 MPa or higher.

7. The silicon nitride-based heat radiation substrate according to claim 5, wherein
the substrate has a thermal conductivity of 85 W/mK or higher.

8. The silicon nitride-based heat radiation substrate according to claim 5, wherein
the substrate has a thickness in a direction perpendicular to its one main face of 220 µm or more and 690 µm or less.
